# EUROPEAN PATENT SPECIFICATION

(11) **EP 3 621 076 B1**
(45) Date of publication and mention of the grant of the patent: **28.09.2022**
(21) Application number: 19192983.5
(22) Date of filing: 22.08.2019
(51) Int. Cl.: G11C 8/08, G11C 11/419

(54) **PULSED APPLICATION OF WORDLINE UNDERDRIVE (WLUD) FOR ENHANCING STABILITY OF STATIC RANDOM ACCESS MEMORY (SRAM) OPERATION IN A LOW SUPPLY VOLTAGE ENVIRONMENT**
GEPULSTE ANWENDUNG EINER WORDLINE-UNTERANSTEUERUNG (WLUD) ZUR VERBESSERUNG DER STABILITÄT EINES STATISCHEN DIREKTZUGRIFFSSPEICHERS (SRAM) IN EINER NIEDERSPANNUNGSUMGEBUNG
APPLICATION PULSÉE DE SOUS-MULTIPLICATEUR DE LIGNE DE MOT (WLUD) POUR AMÉLIORER LA STABILITÉ DE FONCTIONNEMENT D'UNE MÉMOIRE STATIQUE À ACCÈS ALÉATOIRE (SRAM) DANS UN ENVIRONNEMENT À FAIBLE TENSION D'ALIMENTATION

(30) Priority: 04.09.2018 US 201862726502 P; 16.08.2019 US 201916542432
(43) Date of publication of application: 11.03.2020
(73) Proprietor: STMicroelectronics International N.V., 1228 Plan-les-Ouates, Geneva (CH)
(72) Inventor: KUMAR, Ashish, 834009 Ranchi (IN); ALAM, Mohammed Aftab, 804452 Masaurhi, Patna (IN)
(74) Representative: Smith, Gary John

(56) References cited:
- EP-A1- 1 750 273
- US-A1- 2005 281 109
- US-B1- 9 922 702
- US-B1- 9 997 236

## Description

### TECHNICAL FIELD

This disclosure relates to integrated memory circuits and, in particular, to a wordline underdrive assist circuit for a static random access memory (SRAM).

### BACKGROUND

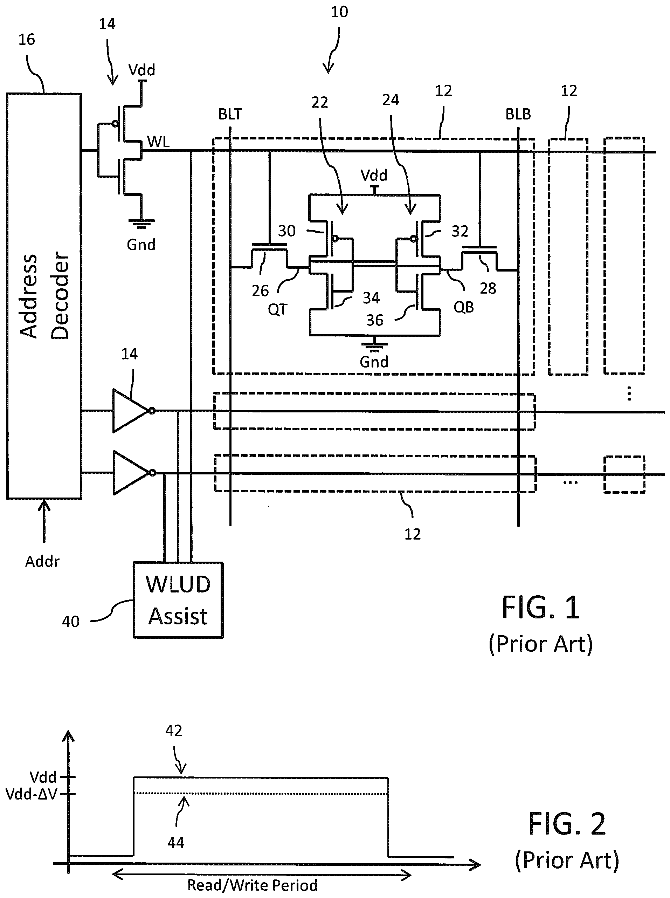

Reference is made to Figure 1 which shows a schematic diagram of a standard memory circuit 10 including a plurality of memory cells 12 that are typically arranged in an array including plural columns and rows. Each memory cell 12 in this implementation is, for example, a conventional six transistor (6T) static random access memory (SRAM) cell 12. The memory circuit 10 further includes a wordline driver 14 for each row and an address decoder 16 configured to control operation of the wordline drivers.

Each memory cell 12 includes two cross-coupled CMOS inverters 22 and 24, each inverter including a series connected p-channel and n-channel MOSFET transistor pair. The inputs and outputs of the inverters 22 and 24 are coupled to form a latch circuit having a true data storage node QT and a complement data storage node QB. The cell 12 further includes two transfer (passgate) transistors 26 and 28 whose gate terminals are driven by a wordline (WL) that is coupled to an output of the wordline driver 14. Transistor 26 is source-drain connected between the true data storage node QT and a node associated with a true bitline (BLT). Transistor 28 is source-drain connected between the complement data storage node QB and a node associated with a complement bitline (BLB). The source terminals of the p-channel transistors 30 and 32 in each inverter 22 and 24 are coupled to receive a high supply voltage (for example, Vdd) at a high supply node, while the source terminals of the n-channel transistors 34 and 36 in each inverter 22 and 24 are coupled to receive a low supply voltage (for example, Gnd) at a low supply node. The high supply voltage Vdd at the high supply node and the low supply voltage Gnd at the low supply node comprise the power supply set of voltages for the cell 12.

The wordline driver circuit 14 includes a series connected p-channel and n-channel MOSFET transistor pair forming a logic inverter. The wordline driver circuit 14 is also coupled to receive the high supply voltage (Vdd) at the high supply node and is referenced to the low supply voltage (Gnd) at the low supply node. The input of the wordline driver circuit 14 is coupled to an output of the address decoder 16 and the wordline (WL) for a row of cells 12 is coupled to the output of the corresponding wordline driver circuit 14. The address decoder 16 receives an address (Addr), decodes the received address and selectively actuates the wordline through the wordline driver circuit 14 to assert a logic high wordline signal.

The SRAM cell 12 is a preferred memory element in many applications, including system on chip (SoC) applications, because of its small size and fast data access operation. The memory circuit 10 will include many SRAM cells 12, and thus the size of each SRAM cell is an important design consideration. Effort is made to use the smallest possible transistor devices for the SRAM cell 12 in order to reduce die area and control cost. However, the use of small transistor devices increases concerns with variation and stability.

It is also of importance to operate the memory circuit 10 at a lowest possible level of the high supply voltage (Vdd). Static noise margin (SNM) is a measure of stability of the SRAM cell 12 during access, and write margin (WM) is a measure of ease of writing data into the cell. Both SNM and WM are reduced with decrease in the high supply voltage Vdd level, and hence there is a corresponding decrease in stability as supply voltage is reduced. Indeed, it is known to those skilled in the art that the SRAM cell 12 becomes unstable due to low SNM at lower supply voltages because the data stored in the cell can flip upon access.

A number of techniques have been developed to assist operation of the SRAM cell 12 when a reduced supply voltage Vdd level is used. One technique is referred to as wordline underdrive (WLUD) where the logic high voltage on the wordline is pulled down by a wordline underdrive assist circuit 40 to a voltage lower than supply voltage in order to provide sufficient static noise margin (SNM) for the read and write operation. When wordline underdrive is active, the logic high voltage level of the wordline signal applied to the gates of the transfer (passgate) transistors 26 and 28 is less than the supply voltage Vdd level. The wordline WL is essentially underdriven by a ΔV voltage such that the logic high voltage level of the asserted wordline signal is at a voltage level of Vdd-ΔV. The effect of the wordline underdrive technique is to reduce the strength of the transfer (passgate) transistors 26 and 28. Figure 2 shows a comparison of a wordline signal voltage for a first case 42 that does not utilize the wordline underdrive technique and a second case 44 that does utilize the wordline underdrive technique.

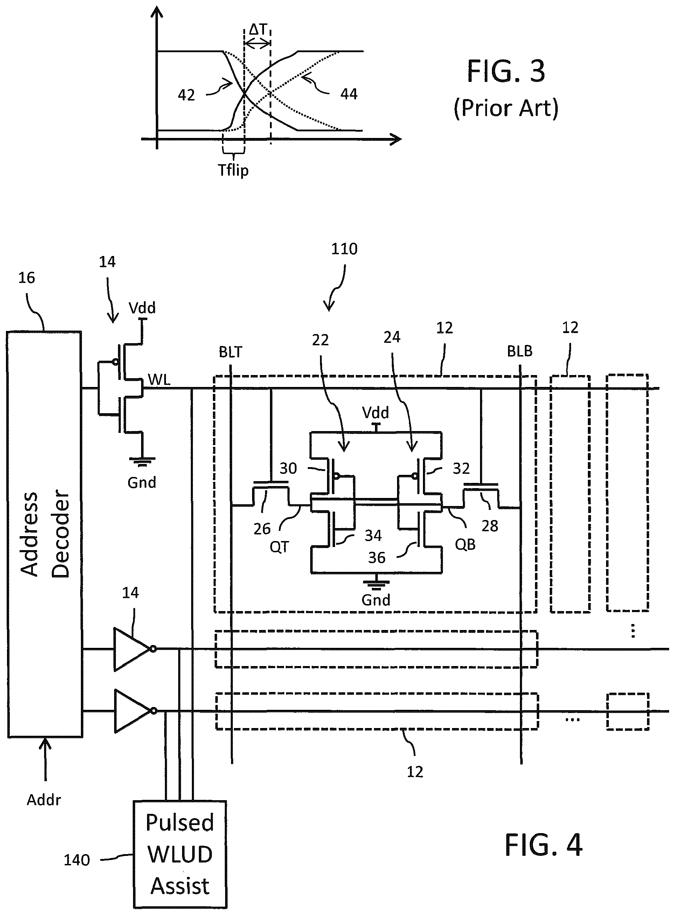

A drawback of the use of the wordline underdrive technique is a decrease in cell current and a corresponding decrease in operational frequency. The application of the reduced wordline voltage increases the flipping time of the cell as shown in Figure 3 where the first case 42 has a flipping time Tflip and the second case has a flipping time Tflip+ΔT.

EP1750273A1 describes a memory cell comprising a bitline, an accessible memory element, an activable switch coupled between the bitline and the access node and a controller configured to activate the activable switch within a first activation period, to activate the activable switch within a second activation period and to deactivate the activable switch at least once when accessing to the accessible memory element during the same access operation.

### SUMMARY

The invention is defined in independent claims 1 and 10. Advantageous embodiments are defined in the dependent claims.

In an aspect, a method comprises: decoding an address to select a wordline coupled to a memory cell; asserting a wordline signal on the selected wordline to perform a write operation at the memory cell, the asserted wordline signal having a leading edge and a trailing edge; and between the leading edge and trailing edge, applying a plurality of wordline underdrive pulses to the asserted wordline signal, each wordline underdrive pulse causing a voltage of the asserted wordline signal to fall from a first voltage level to a second voltage level and then rise from the second voltage level to the first voltage level; wherein the first and second voltage levels are both greater than a ground voltage of the memory cell.

The first voltage level may be equal to a supply voltage of the memory cell.

The method may comprise selecting a magnitude of a difference between the second voltage level and the first voltage level.

The first voltage level may be less than a supply voltage of the memory cell.

The method may comprise: selecting a magnitude of a difference between the supply voltage and the first voltage level; and selecting a magnitude of a difference between the second voltage level and the first voltage level.

There may be an interval between successive wordline underdrive pulses of said plurality of wordline underdrive pulses, the method further comprising selecting the interval.

Each wordline underdrive pulse of said plurality of wordline underdrive pulses may have a duration, the method further comprising selecting the duration.

In an aspect, a method comprises: selecting a wordline coupled to a memory cell; and making a single assertion of a wordline signal on the selected wordline to perform a write operation at the memory cell, wherein the single assertion has a leading edge and a trailing edge and, between the leading edge and trailing edge, the single assertion further includes a plurality of wordline underdrive pulses wherein each wordline underdrive pulse causes a wordline voltage to fall from a first voltage level to a second voltage level and then rise from the second voltage level to the first voltage level; wherein the first and second voltage levels are both greater than a ground voltage of the memory cell.

The first voltage level may be equal to a supply voltage of the memory cell, and further comprising selecting the second voltage level.

The first voltage level may be less than a supply voltage of the memory cell, and further comprising selecting the first and second voltage levels.

There may be an interval between successive wordline underdrive pulses of said plurality of wordline underdrive pulses, the method further comprising selecting the interval.

Each wordline underdrive pulse of said plurality of wordline underdrive pulses may have a duration, the method further comprising selecting the duration.

In an aspect, a circuit comprises: a wordline configured to be coupled to a memory cell powered by a supply voltage; a pull-up transistor having a source-drain path connected between the supply voltage and the wordline wherein the pull-up transistor is actuated in response to selection of the wordline to perform a write operation at the memory cell; a pull-down transistor having a source-drain path connected between the wordline and a ground node; and a control circuit configured to apply a control signal to a control terminal of the pull-down transistor to provide wordline underdrive which includes a plurality of wordline underdrive pulses; wherein each wordline underdrive pulse causes a wordline voltage to fall from a first voltage level to a second voltage level and then rise from the second voltage level to the first voltage level; and wherein the first and second voltage levels are both greater than a ground voltage of the memory cell.

The control circuit may comprise: a bias circuit coupled to a control terminal of the pull-down transistor and configured to set an amount of a fixed wordline underdrive; and a pulse circuit coupled to the control terminal of the pull-down transistor and configured to apply the plurality of wordline underdrive pulses.

The first voltage level may be equal to the supply voltage of the memory cell.

The first voltage level may be less than a supply voltage of the memory cell

In an aspect, a method comprise: selecting a wordline coupled to a memory cell; asserting a wordline signal on the selected wordline to perform a write operation at the memory cell; the asserted wordline signal having a leading edge and a trailing edge; and between the leading edge and trailing edge, applying a plurality of wordline underdrive pulses to the asserted wordline signal, each wordline underdrive pulse causing a voltage of the asserted wordline signal to fall from a first voltage level to a second voltage level and then rise from the second voltage level to the first voltage level; wherein the first and second voltage levels are both greater than a ground voltage of the memory cell.

The method may comprise decoding an address to select the wordline coupled to the memory cell.

The first voltage level may be equal to a supply voltage of the memory cell.

The method may comprise selecting a magnitude of a difference between the second voltage level and the first voltage level.

The first voltage level may be less than a supply voltage of the memory cell.

The method may comprise: selecting a magnitude of a difference between the supply voltage and the first voltage level; and selecting a magnitude of a difference between the second voltage level and the first voltage level

There may be an interval between successive wordline underdrive pulses of said plurality of wordline underdrive pulses, the method further comprising selecting the interval.

Each wordline underdrive pulse of said plurality of wordline underdrive pulses may have a duration, the method further comprising selecting the duration.

Asserting a wordline signal on the selected wordline may comprise making a single assertion of a wordline signal on the selected wordline.

In an aspect, a circuit comprise: a pull-up transistor configured to assert a wordline signal on a wordline in response to a selection of the wordline to perform a write operation at the memory cell, the asserted wordline signal having a leading edge and a trailing edge; a first pull-down transistor configured to apply a plurality of wordline underdrive pulses to the asserted wordline signal between the leading edge and the trailing edge; wherein each wordline underdrive pulse causes a wordline voltage of the asserted wordline signal to fall from a first voltage level to a second voltage level and then rise from the second voltage level to the first voltage level; and wherein the first and second voltage levels are both greater than a ground voltage of the memory cell.

The wordline may be coupled to a memory cell powered by a supply voltage; the pull-up transistor may have a source-drain path connected between the supply voltage and the wordline; and/or the first pull-down transistor may have a source-drain path connected between the wordline and a ground node.

The circuit may comprise a first control circuit configured to apply a control signal to a control terminal of the first pull-down transistor.

The first control circuit may comprise: a pulse circuit coupled to the control terminal of the first pull-down transistor and configured to apply the plurality of wordline underdrive pulses.

The circuit may comprise: a second pull-down transistor configured to apply a fixed wordline underdrive between the leading edge and the trailing edge; and a second control circuit comprising a bias circuit coupled to a control terminal of the second pull-down transistor and configured to set an amount of the fixed wordline underdrive.

The first voltage level may be equal to the supply voltage of the memory cell or the first voltage level may be less than a supply voltage of the memory cell.

The invention relates to a method and a circuit as set forth in the claims.

### BRIEF DESCRIPTION OF THE DRAWINGS

For a better understanding of the disclosure, reference will now be made by way of example only to the accompanying figures in which:
Figure 1 is a schematic diagram of a standard memory circuit with wordline underdrive (WLUD) assist;
Figure 2 is a timing diagram showing a comparison of the wordline voltages when using and not using wordline underdrive;
Figure 3 is a timing diagram showing a comparison of the timing for cell flip when using and not using wordline underdrive;
Figure 4 is a schematic diagram of a memory circuit with pulsed wordline underdrive (WLUD) assist;
Figure 5 is a timing diagram showing an aspect of pulsed wordline underdrive;
Figure 6 is a timing diagram showing another aspect of pulsed wordline underdrive;
Figures 7A-7B are block diagrams of the pulsed wordline underdrive assist circuit; and
Figure 8 illustrates a comparison of operation using a conventional wordline underdrive (as with Figure 1) and the pulsed wordline underdrive (as with Figure 4).

### DETAILED DESCRIPTION OF THE DRAWINGS

Reference is made to Figure 4 which shows a schematic diagram of a memory circuit 110 including a plurality of memory cells 12 that are typically arranged in an array including plural columns and rows. Each memory cell 12 in this implementation is, for example, a conventional six transistor (6T) static random access memory (SRAM) cell 12. The memory circuit 110 further includes a wordline driver 14 for each row and an address decoder 16 configured to control operation of the wordline drivers.

Each memory cell 12 includes two cross-coupled CMOS inverters 22 and 24, each inverter including a series connected p-channel and n-channel MOSFET transistor pair. The inputs and outputs of the inverters 22 and 24 are coupled to form a latch circuit having a true data storage node QT and a complement data storage node QB. The cell 12 further includes two transfer (passgate) transistors 26 and 28 whose gate terminals are driven by a wordline (WL) that is coupled to an output of the wordline driver 14. Transistor 26 is source-drain connected between the true data storage node QT and a node associated with a true bitline (BLT). Transistor 28 is source-drain connected between the complement data storage node QB and a node associated with a complement bitline (BLB). The source terminals of the p-channel transistors 30 and 32 in each inverter 22 and 24 are coupled to receive a high supply voltage (for example, Vdd) at a high supply node, while the source terminals of the n-channel transistors 34 and 36 in each inverter 22 and 24 are coupled to receive a low supply voltage (for example, Gnd) at a low supply node. The high supply voltage Vdd at the high supply node and the low supply voltage Gnd at the low supply node comprise the power supply set of voltages for the cell 12.

The wordline driver circuit 14 includes a series connected p-channel and n-channel MOSFET transistor pair forming a logic inverter. The wordline driver circuit 14 is also coupled to receive the high supply voltage (Vdd) at the high supply node and is referenced to the low supply voltage (Gnd) at the low supply node. The input of the wordline driver circuit 14 is coupled to an output of the address decoder 16 and the wordline (WL) for a row of cells 12 is coupled to the output of the corresponding wordline driver circuit 14. The address decoder 16 receives an address (Addr), decodes the received address and selectively actuates the wordline through the wordline driver circuit 14 to assert a logic high wordline signal.

The memory circuit 110 supports an improved form of wordline underdrive (WLUD) using a pulsed wordline underdrive assist circuit 140. The pulsed wordline underdrive assist circuit 140 is coupled to the wordlines WL and may be selectively actuated by the address decoder 16.

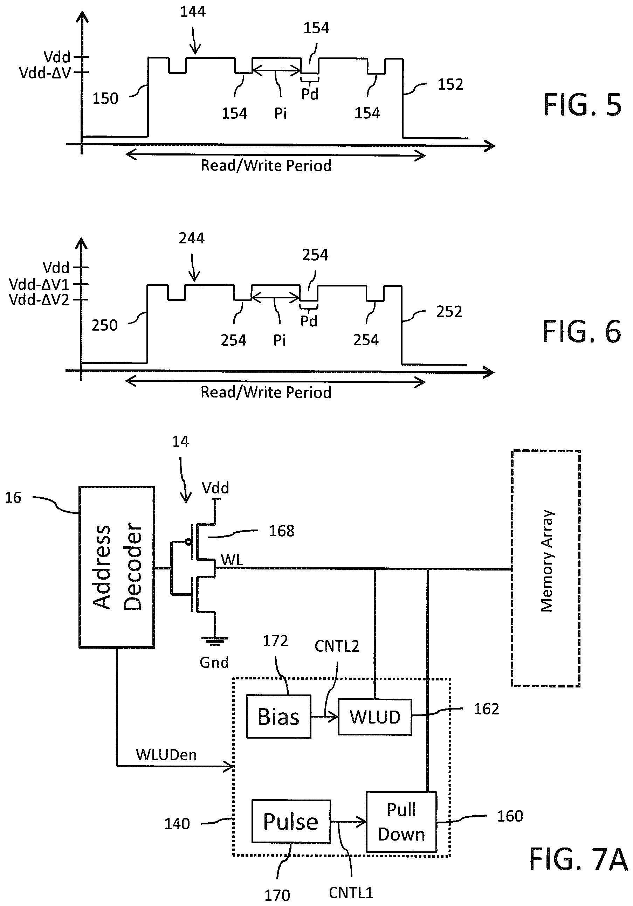

Figure 5 shows a timing diagram for a single assertion 144 of the wordline (responsive to an address decode which selects the wordline) to logic high in accordance with one aspect of the pulsed wordline underdrive technique. The assertion 144 of the wordline by the address decoder 16 through the wordline driver circuit 14 corresponds to a write period and includes a leading edge 150 where the voltage of the wordline signal rises from the low supply voltage (Gnd) to the high supply voltage (Vdd) and a trailing edge 152 where the voltage of the wordline signal falls from the high supply voltage (Vdd) to the low supply voltage (Gnd). In between the leading edge 150 and the trailing edge 152 of the asserted wordline signal, the pulsed wordline underdrive assist circuit 140 applies a plurality of underdrive pulses 154 to the wordline which cause the logic high voltage of the wordline signal to fall by ΔV (where ΔV<Vdd). The value of the ΔV voltage, the duration (Pd) of each underdrive pulse 154 and the value of the interval (Pi) between successive underdrive pulses 154 is configurable by the pulsed wordline underdrive assist circuit 140.

Figure 6 shows a timing diagram for a single assertion 244 of the wordline (responsive to an address decode which selects the wordline) in accordance with another aspect of the pulsed wordline underdrive technique. The assertion 244 of the wordline by the address decoder 16 through the wordline driver circuit 14 corresponds to a write period and includes a leading edge 250 where the voltage of the wordline signal rises from the low supply voltage (Gnd) to a fixed underdrive voltage (Vdd-ΔV1; where ΔV1<Vdd) and a trailing edge 252 where the voltage of the wordline signal falls from the fixed underdrive voltage (Vdd-ΔV1) to the low supply voltage (Gnd). In between the leading edge 250 and the trailing edge 252 of the asserted wordline signal, the pulsed wordline underdrive assist circuit 140 applies a plurality of underdrive pulses 254 to the wordline which cause the logic high voltage of the wordline signal to fall by ΔV2 (where ΔV2<Vdd; and ΔV1+ΔV2<Vdd). The values of the ΔV1 and ΔV2 voltages, the duration (Pd) of each underdrive pulse 254 and the value of the interval (Pi) between successive underdrive pulses 254 is configurable by the pulsed wordline underdrive assist circuit 140.

Reference is now made to Figure 7A which shows a block diagram of the pulsed wordline underdrive assist circuit 140. A pull-down circuit 160 is coupled between the wordline WL and the low supply voltage (Gnd) node. The conductivity of the pull-down circuit 160 is controlled by a first control signal CNTL1. The first control signal CNTL1 is modulated by a pulse circuit 170. The pulse circuit 170 can apply pulses to the pull-down circuit 160 for selecting the voltage level ΔV or ΔV2 of the pulses for the pulsed wordline underdrive assist. A wordline underdrive circuit 162 is coupled between the wordline WL and the low supply voltage (Gnd) node. The conductivity of the wordline underdrive circuit 162 is controlled by a second control signal CNTL2. The second control signal CNTL2 is modulated by a bias circuit 172. The bias circuit 172 can apply a bias to the pull-down circuit 160 for selecting the voltage level ΔV1 for the fixed underdrive voltage. The pulsed wordline underdrive assist circuit 140 is enabled for operation by a wordline underdrive enable signal (WLUDen) generated by the address decoder. The pulse circuit 170 is configurable to select the values of the ΔV or ΔV2 voltages, the duration (Pd) and the value of the interval (Pi). The bias circuit 172 is configurable to select the magnitude of the voltage level ΔV1.

In an aspect, the pull-down circuit 160 may comprise an n-channel pull-down transistor that is source-drain coupled between the wordline WL and the low supply voltage (Gnd) node. The first control signal CNTL1 is applied to the gate of the pull-down transistor. The pull-down transistor of the pull-down circuit 160 and the p-channel pull-up transistor 168 of the driver 12 form a voltage divider circuit when both transistors are active and this voltage division sets the voltage level at the wordline for implementing the pulses for the pulsed wordline underdrive assist.

In an aspect, the wordline underdrive circuit 162 may comprise an n-channel pull-down transistor that is source-drain coupled between the wordline WL and the low supply voltage (Gnd) node. The second control signal CNTL2 is applied to the gate of the pull-down transistor. The pull-down transistor of the pull-down circuit 162 and the p-channel pull-up transistor 168 of the driver 12 form a voltage divider circuit when both transistors are active and this voltage division sets the voltage level at the wordline for implementing the wordline underdrive.

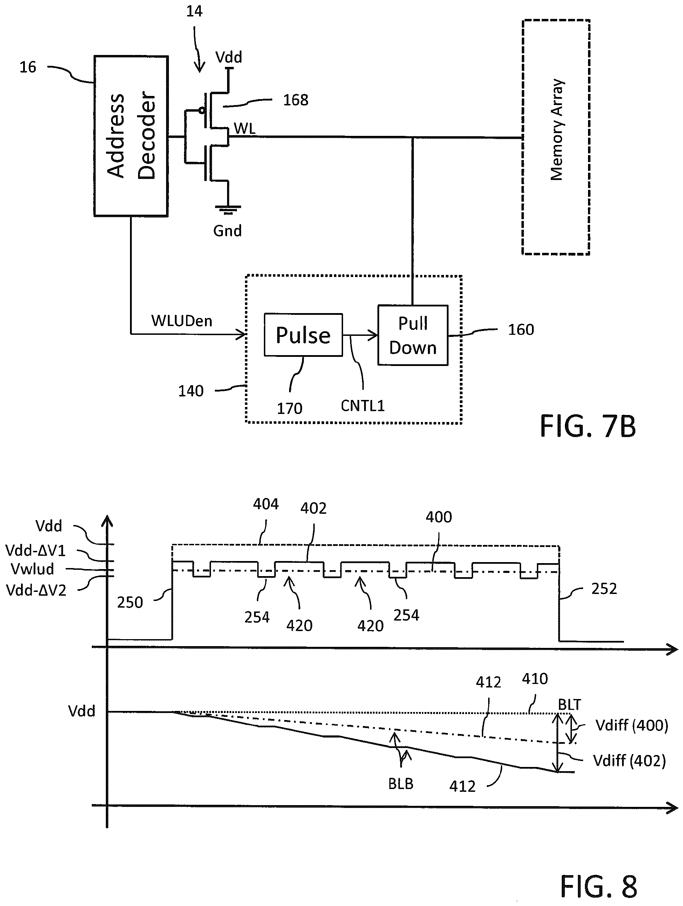

It will be understood that the wordline underdrive circuit 162 may be omitted, or alternatively selectively disabled, so that the pulsed wordline underdrive assist applies only the pulses. An example of such an implementation is shown in Figure 7B.

Reference is now made to Figure 8 which illustrates a comparison of operation using a conventional wordline underdrive (as with Figure 1) and the pulsed wordline underdrive (as with Figure 4). The top part of Figure 8 shows the assertion of the wordline signal with the conventional wordline underdrive (reference 400), the assertion of the wordline signal with the pulsed wordline underdrive (reference 402) and the assertion of the wordline without any form of wordline underdrive (reference 404). In each case, the assertion of the wordline signal has a leading edge 250 and a trailing edge 252. Between the edges 250 and 252, the wordline signal without any form of wordline underdrive (reference 404) is at a voltage level of Vdd. Between the edges 250 and 252, the wordline signal with the conventional wordline underdrive (reference 400) is at a voltage level of Vwlud, where Vwlud<Vdd. Between the edges 250 and 252, the wordline signal with the pulsed wordline underdrive (reference 402) has a maximum voltage of Vdd-ΔV1 (the fixed underdrive voltage, where ΔV1<Vdd) that is greater than Vwlud, and includes a plurality of underdrive pulses 254 where, for each pulse, the voltage of the asserted wordline signal falls to a voltage of Vdd-ΔV2 (where ΔV2<Vdd; and ΔV1+ΔV2<Vdd) that is lower than Vwlud.

The bottom part of Figure 8 shows the bitline voltages in response to the assertion of the wordline signal with the conventional wordline underdrive (reference 400) and the assertion of the wordline signal with the pulsed wordline underdrive (reference 402). In particular, it will be noted that there is an increased difference (Vdiff) between the true bitline (BLT) voltage 410 and the complement bitline (BLB) voltage 412 with use of the pulsed wordline underdrive (reference 402) compared to the conventional wordline underdrive (reference 400).

The use of the pulsed wordline underdrive (reference 402) provides a benefit during write operations. The lower wordline underdrive requirement or better wordline voltage level provides for improved write windows 420 (between consecutive pulses 254) compared to the conventional wordline underdrive (reference 400).

The foregoing description has provided by way of exemplary and non-limiting examples. However, various modifications and adaptations may become apparent to those skilled in the relevant arts in view of the foregoing description, when read in conjunction with the accompanying drawings and the appended claims. However, all such and similar modifications within in the scope of the appended claims fall within the scope of the invention.

## Claims

1. A method, comprising:
selecting a wordline coupled to a memory cell (12) of a static random memory, SRAM, (110);
asserting a wordline signal on the selected wordline to perform a write operation at the memory cell (12), the asserted wordline signal having a leading edge and a trailing edge; and
between the leading edge and trailing edge, applying a plurality of wordline underdrive pulses to the asserted wordline signal, each wordline underdrive pulse causing a voltage of the asserted wordline signal to fall from a first voltage level to a second voltage level and then rise from the second voltage level to the first voltage level;
wherein the first voltage level is greater than a ground voltage of the memory cell (12);
wherein the second voltage level is greater than the ground voltage of the memory cell (12).

2. The method of claim 1, further comprising decoding an address to select the wordline coupled to the memory cell (12).

3. The method of any of claims 1 and 2, wherein the first voltage level is equal to a supply voltage of the memory cell (12).

4. The method of any of claims 1 to 3, further comprising selecting a magnitude of a difference between the second voltage level and the first voltage level.

5. The method of any of claims 1 and 2, wherein the first voltage level is less than a supply voltage of the memory cell (12).

6. The method of claim 5, further comprising:
selecting a magnitude of a difference between the supply voltage and the first voltage level; and
selecting a magnitude of a difference between the second voltage level and the first voltage level.

7. The method of any of claims 1 to 6, wherein there is an interval between successive wordline underdrive pulses of said plurality of wordline underdrive pulses, the method further comprising selecting the interval.

8. The method of claim 1, wherein each wordline underdrive pulse of said plurality of wordline underdrive pulses has a duration, the method further comprising selecting the duration.

9. The method of any of claims 1 to 8, wherein asserting a wordline signal on the selected wordline comprises
making a single assertion of a wordline signal on the selected wordline

10. A static random memory, SRAM, (110) comprising a memory cell (12) and a circuit (140), the circuit comprising:
a pull-up transistor (14) configured to assert a wordline signal on a wordline in response to a selection of the wordline to perform a write operation at the memory cell (12), the asserted wordline signal having a leading edge and a trailing edge;
a first pull-down transistor (160) configured to apply a plurality of wordline underdrive pulses to the asserted wordline signal between the leading edge and the trailing edge;
wherein each wordline underdrive pulse causes a wordline voltage of the asserted wordline signal to fall from a first voltage level to a second voltage level and then rise from the second voltage level to the first voltage level; and
wherein the first voltage level is greater than a ground voltage of the memory cell (12);
wherein the second voltage level is greater than the ground voltage of the memory cell (12).

11. The SRAM (110) of claim 10, wherein the wordline is coupled to the memory cell (12) powered by a supply voltage;
wherein the pull-up transistor (14) has a source-drain path connected between the supply voltage and the wordline; and/or
wherein the first pull-down transistor (160) has a source-drain path connected between the wordline and a ground node.

12. The SRAM (110) of any of claims 10 and 11, wherein the circuit (140) comprises a first control circuit (170) configured to apply a control signal to a control terminal of the first pull-down transistor (160).

13. The SRAM (110) of claim 12, wherein the first control circuit (170) comprises:
a pulse circuit (170) coupled to the control terminal of the first pull-down transistor (160) and configured to apply the plurality of wordline underdrive pulses.

14. The SRAM (110) of any of claims 10 to 13, further comprising:
a second pull-down transistor (160) configured to apply a fixed wordline underdrive between the leading edge and the trailing edge; and
a second control circuit (172) comprising a bias circuit (172) coupled to a control terminal of the second pull-down transistor (162) and configured to set an amount of the fixed wordline underdrive.

15. The SRAM (110) of claim 13, wherein the first voltage level is equal to the supply voltage of the memory cell (12) or the first voltage level is less than a supply voltage of the memory cell (12).

## Patentansprüche

1. Verfahren, aufweisend:
Auswählen einer Wortleitung, die mit einer Speicherzelle (12) eines statischen Direktspeichers, SRAM, (110) gekoppelt ist;
Aktivieren eines Wortleitungssignals auf der ausgewählten Wortleitung, um eine Schreiboperation an der Speicherzelle (12) durchzuführen, wobei das aktivierte Wortleitungssignal eine Vorderflanke und eine Rückflanke hat; und
zwischen der Vorderflanke und der Rückflanke Anlegen mehrerer Wortleitungs-Untersteuerungsimpulse an das aktivierte Wortleitungssignal, wobei jeder Wortleitungs-Untersteuerungsimpuls bewirkt, dass eine Spannung des aktivierten Wortleitungssignals von einem ersten Spannungspegel auf einen zweiten Spannungspegel abfällt und dann vom zweiten Spannungspegel auf den ersten Spannungspegel ansteigt;
wobei der erste Spannungspegel größer als eine Massespannung der Speicherzelle (12) ist;
wobei der zweite Spannungspegel größer als die Massespannung der Speicherzelle (12) ist.

2. Verfahren nach Anspruch 1, ferner aufweisend ein Decodieren einer Adresse, um die mit der Speicherzelle (12) gekoppelte Wortleitung auszuwählen.

3. Verfahren nach einem der Ansprüche 1 und 2, bei welchem der erste Spannungspegel gleich einer Versorgungsspannung der Speicherzelle (12) ist.

4. Verfahren nach einem der Ansprüche 1 bis 3, ferner aufweisend ein Auswählen einer Größe einer Differenz zwischen dem zweiten Spannungspegel und dem ersten Spannungspegel.

5. Verfahren nach einem der Ansprüche 1 und 2, bei welchem der erste Spannungspegel kleiner als eine Versorgungsspannung der Speicherzelle (12) ist.

6. Verfahren nach Anspruch 5, ferner aufweisend:
Auswählen einer Größe einer Differenz zwischen der Versorgungsspannung und dem ersten Spannungspegel; und
Auswählen einer Größe einer Differenz zwischen dem zweiten Spannungspegel und dem ersten Spannungspegel.

7. Verfahren nach einem der Ansprüche 1 bis 6, bei welchem es ein Intervall zwischen aufeinanderfolgenden Wortleitungs-Untersteuerungsimpulsen der mehreren Wortleitungs-Untersteuerungsimpulse gibt, wobei das Verfahren ferner ein Auswählen des Intervalls aufweist.

8. Verfahren nach Anspruch 1, bei welchem jeder Wortleitungs-Untersteuerungsimpuls der mehreren Wortleitungs-Untersteuerungsimpulse eine Dauer hat, wobei das Verfahren ferner ein Auswählen der Dauer aufweist.

9. Verfahren nach einem der Ansprüche 1 bis 8, bei welchem das Aktivieren eines Wortleitungssignals auf der ausgewählten Wortleitung ein Machen einer einzigen Aktivierung eines Wortleitungssignals auf der ausgewählten Wortleitung aufweist.

10. Statischer Direktspeicher, SRAM, (110), der eine Speicherzelle (12) und eine Schaltung (140) aufweist, wobei die Schaltung aufweist:
einen Pull-up-Transistor (14), der konfiguriert ist, um ein Wortleitungssignal auf einer Wortleitung als Reaktion auf eine Auswahl der Wortleitung zu aktivieren, um eine Schreiboperation an der Speicherzelle (12) durchzuführen, wobei das aktivierte Wortleitungssignal eine Vorderflanke und eine Rückflanke hat;
einen ersten Pull-down-Transistor (160), der konfiguriert ist, um mehrere Wortleitungs-Untersteuerungsimpulse auf das aktivierte Wortleitungssignal zwischen der Vorderflanke und der Rückflanke anzulegen;
wobei jeder Wortleitungs-Untersteuerungsimpuls bewirkt, dass eine Wortleitungsspannung des aktivierten Wortleitungssignals von einem ersten Spannungspegel auf einen zweiten Spannungspegel abfällt und dann vom zweiten Spannungspegel auf den ersten Spannungspegel ansteigt; und
wobei der erste Spannungspegel größer als eine Massespannung der Speicherzelle (12) ist;
wobei der zweite Spannungspegel größer als die Massespannung der Speicherzelle (12) ist.

11. SRAM (110) nach Anspruch 10, bei welchem die Wortleitung mit der Speicherzelle (12) gekoppelt ist, die von einer Versorgungsspannung mit Energie versorgt wird; wobei der Pull-up-Transistor (14) einen Source-Drain-Pfad hat, der zwischen der Versorgungsspannung und der Wortleitung verbunden ist; und/oder wobei der erste Pull-down-Transistor (160) einen Source-Drain-Pfad hat, der zwischen der Wortleitung und einem Masseknoten verbunden ist.

12. SRAM (110) nach einem der Ansprüche 10 und 11, bei welchem die Schaltung (140) eine erste Steuerschaltung (170) aufweist, die konfiguriert ist, um ein Steuersignal an einen Steueranschluss des ersten Pull-down-Transistors (160) anzulegen.

13. SRAM (110) nach Anspruch 12, bei welchem die erste Steuerschaltung (170) eine Impulsschaltung (170) aufweist, die mit dem Steueranschluss des ersten Pull-down-Transistors (160) gekoppelt ist und konfiguriert ist, um die mehreren Wortleitungs-Untersteuerungsimpulse anzulegen.

14. SRAM (110) nach einem der Ansprüche 10 bis 13, ferner aufweisend:
einen zweiten Pull-down-Transistor (160), der konfiguriert ist, um eine feste Wortleitungs-Untersteuerung zwischen der Vorderflanke und der Rückflanke anzubringen; und
eine zweite Steuerschaltung (172) mit einer Vorspannungsschaltung (172), die mit einem Steueranschluss des zweiten Pull-down-Transistors (162) gekoppelt ist und konfiguriert ist, um eine Menge der festen Wortleitungsuntersteuerung einzustellen.

15. SRAM (110) nach Anspruch 13, bei welchem der erste Spannungspegel gleich der Versorgungsspannung der Speicherzelle (12) ist oder der erste Spannungspegel kleiner als eine Versorgungsspannung der Speicherzelle (12) ist.

## Revendications

1. Procédé consistant à :
sélectionner une ligne de mot couplée à une cellule mémoire (12) d'une mémoire vive statique (SRAM) (110) ;
affirmer un signal de ligne de mot sur la ligne de mot sélectionnée pour effectuer une opération d'écriture au niveau de la cellule mémoire (12), le signal de ligne de mot affirmé ayant un front avant et un front arrière ; et
entre le bord avant et le bord arrière, appliquer une pluralité d'impulsions d'attaque réduite de ligne de mot au signal de ligne de mot affirmé, chaque impulsion d'attaque réduite de ligne de mot provoquant la chute d'une tension du signal de ligne de mot affirmé an allant d'un premier niveau de tension jusqu'à un deuxième niveau de tension, puis sa montée en allant du deuxième niveau de tension jusqu'au premier niveau de tension,
dans lequel le premier niveau de tension est supérieur à une tension de terre de la cellule mémoire (12),
dans lequel le deuxième niveau de tension est supérieur à la tension de terre de la cellule mémoire (12).

2. Procédé selon la revendication 1, consistant en outre à décoder une adresse pour sélectionner la ligne de mot couplée à la cellule mémoire (12).

3. Procédé selon l'une quelconque des revendications 1 et 2, dans lequel le premier niveau de tension est égal à une tension d'alimentation de la cellule mémoire (12).

4. Procédé selon l'une quelconque des revendications 1 à 3, consistant en outre à sélectionner une amplitude d'une différence entre le deuxième niveau de tension et le premier niveau de tension.

5. Procédé selon l'une quelconque des revendications 1 et 2, dans lequel le premier niveau de tension est inférieur à une tension d'alimentation de la cellule mémoire (12).

6. Procédé selon la revendication 5, consistant en outre à :
sélectionner une amplitude d'une différence entre la tension d'alimentation et le premier niveau de tension ; et
sélectionner une amplitude d'une différence entre le deuxième niveau de tension et le premier niveau de tension.

7. Procédé selon l'une quelconque des revendications 1 à 6, dans lequel il existe un intervalle entre des impulsions d'attaque réduite de ligne de mot successives de ladite pluralité d'impulsions d'attaque réduite de ligne de mot, le procédé consistant en outre à sélectionner l'intervalle.

8. Procédé selon la revendication 1, dans lequel chaque impulsion d'attaque réduite de ligne de mot de ladite pluralité d'impulsions d'attaque réduite de ligne de mot a une durée, le procédé consistant en outre à sélectionner la durée.

9. Procédé selon l'une quelconque des revendications 1 à 8, dans lequel l'affirmation d'un signal de ligne de mot sur la ligne de mot sélectionnée consiste à :
réaliser une seule affirmation d'un signal de ligne de mot sur la ligne de mot sélectionnée.

10. Mémoire vive statique (SRAM) (110) comprenant une cellule mémoire (12) et un circuit (140), the circuit comprenant :
un transistor de tirage ou pull-up (14) configuré pour affirmer un signal de ligne de mot sur une ligne de mot en réponse à une sélection de la ligne de mot pour effectuer une opération d'écriture au niveau de la cellule mémoire (12), le signal de ligne de mot affirmé ayant un front avant et un front arrière ;
un premier transistor de rappel ou pull-down (160) configuré pour appliquer une pluralité d'impulsions d'attaque réduite de ligne de mot au signal de ligne de mot affirmé entre le front avant et le front arrière,
dans lequel chaque impulsion d'attaque réduite de ligne de mot provoque la chute d'une tension de ligne de mot du signal de ligne de mot affirmé en allant d'un premier niveau de tension jusqu'à un deuxième niveau de tension, puis sa montée en allant du deuxième niveau de tension jusqu'au premier niveau de tension, et
dans lequel le premier niveau de tension est supérieur à une tension de terre de la cellule mémoire (12),
dans lequel le deuxième niveau de tension est supérieur à la tension de terre de la cellule mémoire (12).

11. SRAM (110) selon la revendication 10, dans lequel la ligne de mot est couplée à la cellule mémoire (12) alimentée par une tension d'alimentation,
dans lequel le transistor de tirage ou pull-up (14) a un chemin source-drain relié entre la tension d'alimentation et la ligne de mot, et/ou
dans lequel le premier transistor de rappel ou pull-down (160) a un chemin source-drain relié entre la ligne de mot et un nœud de terre.

12. SRAM (110) selon l'une quelconque des revendications 10 et 11, dans lequel le circuit (140) comprend un premier circuit de commande (170) configuré pour appliquer un signal de commande à une borne de commande du premier transistor de rappel ou pull-down (160).

13. SRAM (110) selon la revendication 12, dans lequel le premier circuit de commande (170) comprend :
un circuit d'impulsions (170) couplé à la borne de commande du premier transistor de rappel ou pull-down (160), et configuré pour appliquer la pluralité d'impulsions d'attaque réduite de ligne de mot.

14. SRAM (110) selon l'une quelconque des revendications 10 à 13, comprenant en outre :
un deuxième transistor de rappel ou pull-down (160) configuré pour appliquer une attaque réduite de ligne de mot fixe entre le front avant et le front arrière ; et
un deuxième circuit de commande (172) comprenant un circuit de polarisation (172) couplé à une borne de commande du deuxième transistor de rappel ou pull-down (162), et configuré pour régler une quantité de l'attaque réduite de ligne de mot fixe.

15. SRAM (110) selon la revendication 13, dans lequel le premier niveau de tension est égal à la tension d'alimentation de la cellule mémoire (12), ou dans lequel le premier niveau de tension est inférieur à une tension d'alimentation de la cellule mémoire (12).
